# EUROPÄISCHE PATENTANMELDUNG

(11) **EP 4 691 826 A1**
(43) Veröffentlichungstag der Anmeldung: **11.02.2026**
(21) Anmeldenummer: 24193431.4
(22) Anmeldetag: 07.08.2024
(51) Int. Cl.: B60L 1/00, B60L 3/00, B60R 16/023, B60R 16/033, G01R 31/00

(54) **VERFAHREN ZUM BESTIMMEN EINES FAHRZEUGBATTERIEZUSTANDES, DIAGNOSEVORRICHTUNG UND SYSTEM**

(71) Anmelder: Hella Gutmann Solutions GmbH, 79241 Ihringen (DE)
(72) Erfinder: Frödrich, Matthias, 79312 Emmendingen (DE); Abraham, Heiko, 79241 Wasenweiler (DE); Kolberg, Ralph, 79111 Freiburg i.Br. (DE)
(74) Vertreter: Pfenning, Meinig & Partner mbB

(57) **Zusammenfassung**

Die vorliegende Erfindung betrifft ein Verfahren zum Bestimmen eines Batteriezustandes einer Fahrzeugbatterie, wobei die Fahrzeugbatterie eine Nennspannung von weniger als 48 V aufweist, sowie ein Verfahren zum Bestimmen eines Lichtmaschinenzustandes einer Lichtmaschine, welche ausgestaltet ist, eine Fahrzeugbatterie aufzuladen, wobei die Fahrzeugbatterie eine Nennspannung von weniger als 48 V aufweist. Die Erfindung betrifft weiter eine Diagnosevorrichtung zum Durchführen der genannten Verfahren.

## Beschreibung

Die vorliegende Erfindung betrifft ein Verfahren zum Bestimmen eines Batteriezustandes einer Fahrzeugbatterie, wobei die Fahrzeugbatterie eine Nennspannung von weniger als 48 V aufweist. Die Erfindung betrifft weiter eine Diagnosevorrichtung und ein System zum Durchführen des Verfahrens.

Für herkömmliche Fahrzeugbatterien, welche üblicherweise eine Nennspannung von 12 V aufweisen, werden derzeit dedizierte Werkzeuge für eine Batteriediagnose oder eine Bewertung des Batteriezustandes verwendet, da herkömmliche Fahrzeuge keine oder erst zu spät Informationen zum Batteriezustand zur Verfügung stellen. Hierfür werden die Werkzeuge direkt vor Ort an das Fahrzeug bzw. an die Fahrzeugbatterie angeschlossen. Üblicherweise wird hierzu zunächst der Autoschlüssel aus dem Zündschloss gezogen. Danach wird die Motorhaube geöffnet, um den Zugang zur Fahrzeugbatterie zu ermöglichen. Danach werden Minuspol und Pluspol der Batterie mit einem schwarzen bzw. einem roten Kabel angeklemmt, um die von der Fahrzeugbatterie bereitgestellte Spannung und den Strom zu messen.

Nach Ausführung der Tests, erhält der Nutzer ein auf dem Werkzeug angezeigtes Ergebnis. Kombinationen hiervon sind auch möglich. Diese lokale Batteriediagnose benötigt zur Durchführung allerdings einen erheblichen Zeitaufwand. So ist es nicht ungewöhnlich, dass ca. 20 Minuten vom Start der Durchführung bis zum Ergebnis des Tests vergehen. Weiter sollten Kfz-Kenntnisse für die Durchführung des Verfahrens vorhanden sein, weshalb meistens nur geschultes Fachpersonal für die Durchführung der Batteriediagnose in Frage kommt.

Selbst in Elektrofahrzeugen und Hybridfahrzeugen, welche einen Elektromotor für den Antrieb und eine Traktionsbatterie zur Stromversorgung des Elektromotors aufweisen, können zwar Eigenschaften der Traktionsbatterie wie Ladestatus ausgelesen oder angezeigt werden. Die Fahrzeugbatterie ist zumeist allerdings von der Traktionsbatterie entkoppelt und bildet mit dem Fahrzeugbordnetz ein eigenständiges System. Selbst wenn die Traktionsbatterie voll ist, kann es vorkommen, dass das Fahrzeug aufgrund einer leeren Fahrzeugbatterie nicht losfahren kann. Somit kann der Zustand der Fahrzeugbatterie auch in Elektrofahrzeugen und Hybridfahrzeugen nur über die oben beschriebene Messung bestimmt werden.

Es wäre wünschenswert, wenn die Zeit für eine Batteriediagnose reduziert werden kann. Weiter wäre es von Vorteil, wenn die Batteriediagnose einfacher und flexibler durchgeführt werden kann.

Wenn die Batteriediagnose wie oben durchgeführt wird, kann es sein, dass im Falle einer defekten Fahrzeugbatterie die Empfehlung "Batterie wechseln" ausgesprochen wird, aber dass die Ursache für die defekte Fahrzeugbatterie in einer fehlerhaften Lichtmaschine liegt. Das Austauschen der defekten Fahrzeugbatterie durch eine neue Fahrzeugbatterie löst in diesem Fall nicht das Problem der fehlerhaften Lichtmaschine, und es ist wahrscheinlich, dass die fehlerhafte Lichtmaschine die neue Fahrzeugbatterie beschädigt, wodurch diese bald wieder ausgetauscht werden muss.

Die vorliegende Erfindung wird unter anderem durch die Gegenstände der Ansprüche definiert. Vorteilhafte Weiterbildungen werden in der nachfolgenden Beschreibung beschrieben.

Gemäß einem ersten Aspekt wird ein Verfahren zum Bestimmen eines Batteriezustandes einer Fahrzeugbatterie bereitgestellt. Die Fahrzeugbatterie weist hierbei eine Nennspannung von weniger als 48 V auf.

Das Verfahren umfasst die Schritte:
- Empfangen mindestens einer Betriebsinformation von einem Fahrzeugsteuergerät, wobei die Betriebsinformation charakteristisch für den Batteriezustand der Fahrzeugbatterie ist oder mit dem Batteriezustand korreliert,
- Bestimmen des Batteriezustandes mithilfe der mindestens einen Betriebsinformation.

Moderne Fahrzeuge sind fortschrittliche Technologieträger und haben allesamt eine Vielzahl von Fahrzeugsteuergeräten (ECUs). Die vorliegende Schrift nutzt die Erkenntnis, dass sich der Batteriezustand aus Betriebsinformationen des Fahrzeuges ermitteln lässt, ohne dass eine Messung vor Ort mittels Spezialwerkzeugen an der Fahrzeugbatterie durch einen Kfz-Mechaniker notwendig ist. Hierbei können nicht nur Steuergeräte, die unmittelbar mit der Fahrzeugbatterie zusammenhängen, wie Fahrzeugbatteriesteuergerät, Lichtmaschinensteuergerät, sondern insbesondere auch solche Steuergeräte abgefragt werden, die nicht unmittelbar oder lediglich mittelbar mit der Fahrzeugbatterie zu tun haben, wie Antriebssteuergeräte oder Komfortsteuergeräte. Die Betriebsinformation kann auch an einem vom Fahrzeug entfernten Ort empfangen und ausgewertet werden, wodurch sich das Verfahren ebenfalls gut für Fahrzeugflotten und "Remote"-Anwendungen eignet. Das Verfahren kann während des Betriebs des Fahrzeuges und/oder während einer Fahrt durchgeführt werden. Selbstverständlich kann das Verfahren auch klassisch in einer Fahrzeugwerkstatt oder im Pannenfall bzw. beim Liegenbleiben des Fahrzeuges vor Ort durchgeführt werden.

Das "Bestimmen des Batteriezustandes" kann auch als "Durchführen einer Batteriediagnose" aufgefasst werden. Die Begriffe werden in der vorliegenden Schrift synonym verwendet.

Das Verfahren kann zusätzlich die folgenden Schritte aufweisen:
- Senden mindestens einer Anfrage an das Fahrzeug, insbesondere an das mindestens eine fahrzeugseitige Steuergerät, um die Betriebsinformation bereitzustellen, und
- Empfangen mindestens einer Fahrzeugantwort von dem Fahrzeug, insbesondere von dem mindestens einen fahrzeugseitigen Steuergerät.

Die mindestens eine Fahrzeugantwort kann hierbei die Betriebsinformation umfassen. Mit der Anfrage kann also die Betriebsinformation aktiv angefragt werden, wodurch das Verfahren initiiert werden kann. Die Anfrage kann insbesondere eine Aufforderung zum Bereitstellen der Betriebsinformation enthalten. Anstelle der aktiven Anfrage kann auch vorgesehen sein, dass die Betriebsinformation durch das Fahrzeug selbst bereitgestellt wird und automatisch gesendet wird, wenn eine Verbindung mit dem Fahrzeug hergestellt wird. In diesem Fall ist das "Empfangen der Betriebsinformation" als passives Zuhören zu verstehen.

Die Anfrage kann enthalten: Bereitstellen von aktuellen Betriebsinformationen. Falls im Fahrzeug oder im Steuergerät keine aktuellen Betriebsinformationen vorliegen, kann das fahrzeugseitige Steuergerät mindestens ein weiteres Steuergerät oder einen Sensor dazu auffordern, eine aktuelle Betriebsinformation bereitzustellen.

Die Betriebsinformation kann Betriebsinformation einer Fahrzeugkomponente, eines Sensors und/oder eines Fahrzeugsteuergeräts sein oder umfassen. Die Fahrzeugkomponente kann zum Beispiel eine Fahrzeugbatterie, eine Lichtmaschine, eine Antriebskomponente und/oder eine Komfortkomponente des Fahrzeuges sein. Das Steuergerät kann der Fahrzeugkomponente zuordnet sein und zusammen mit der Fahrzeugkomponente und optional noch mindestens einem Sensor eine Einheit bilden. Die Fahrzeugkomponente und das Steuergerät können auch durch dieselbe Komponente gebildet sein; die Fahrzeugkomponente bildet also in diesem Fall das Steuergerät. In diesem Fall werden also Betriebsinformationen des Steuergerätes selbst ausgewertet, um den Batteriezustand zu bestimmen. Dies kann zum Beispiel beim Gateway der Fall sein (s. unten).

Es können auch mehrere Betriebsinformationen einer einzigen Fahrzeugkomponente für die Bestimmung des Batteriezustandes herangezogen werden. Weiter können auch Betriebsinformationen von mehreren Fahrzeugkomponenten für die Bestimmung des Batteriezustandes verwendet werden. Es kann also vorgesehen sein, dass Betriebsinformationen von mindestens zwei verschiedenen Fahrzeugkomponenten empfangen werden, und der Batteriezustand mithilfe der empfangenen Betriebsparameter bestimmt wird. Falls eine bestimmte Betriebsinformation einer Fahrzeugkomponente für eine zuverlässige Bestimmung des Batteriezustandes noch fehlt, kann hiernach aktiv gefragt werden, beispielsweise über eine weitere Anfrage.

Die Betriebsinformation wird durch das mindestens eine fahrzeugseitige Steuergerät bereitgestellt und/oder an eine fahrzeugexterne Komponente versandt, beispielsweise direkt oder zumindest indirekt über einen Fahrzeugbussystem und ein fahrzeugseitiges Gateway. Beispielsweise ist oder umfasst das fahrzeugseitige Steuergerät ein Batteriesteuergerät, Bordnetzsteuergerät, Lichtmaschinensteuergerät, Motorsteuergerät und/oder Gateway.

Es können auch mehrere Betriebsinformationen eines Steuergerätes für die Bestimmung des Batteriezustandes herangezogen werden. Weiter können auch Betriebsinformationen von mehreren Steuergeräten für die Bestimmung des Batteriezustandes verwendet werden. Es kann also vorgesehen sein, dass Betriebsinformationen von mindestens zwei verschiedenen fahrzeugseitigen Steuergeräten empfangen werden, und der Batteriezustand mithilfe der empfangenen Betriebsparameter bestimmt wird. Falls eine bestimmte Betriebsinformation für eine zuverlässige Bestimmung des Batteriezustandes noch fehlt, kann hiernach aktiv gefragt werden, beispielsweise über eine entsprechende Anfrage.

Das Fahrzeug kann neben dem genannten fahrzeugseitigen Steuergerät ein Batteriesteuergerät und/oder ein Lichtmaschinensteuergerät umfassen, wobei für die Bestimmung des Batteriezustandes zusätzlich zur genannten Betriebsinformation mindestens eine Betriebsinformation des Batteriesteuergerätes und/oder des Lichtmaschinensteuergerätes herangezogen wird.

Die Betriebsinformation umfasst zum Beispiel einen Betriebsparameter der Fahrzeugkomponente und/oder einen Betriebszustand der Fahrzeugkomponente. Konkret kann die Betriebsinformation zum Beispiel mindestens eines der folgenden Elemente umfassen oder sein: Fehlercode, DTC, Temperatur, Spannung, Strom und/oder elektrischer Widerstand.

Es kann manchmal ausreichen, dass Betriebsparameter für die Bestimmung des Batteriezustandes herangezogen werden, ohne dass der Betriebszustand genutzt wird. Der mindestens eine Betriebsparameter kann durch einen Sensor, wie einen im Fahrzeug, insbesondere an oder in der Fahrzeugkomponente, verbauten Sensor gemessen werden und/oder aus durch den Sensor ermittelten Messwerten ermittelt werden. Der Sensor kann einer Fahrzeugkomponente zugeordnet sein. So kann eine durch einen Fahrzeugbatterietemperatursensor gemessene hohe/niedrige Temperatur der Fahrzeugbatterie Information über den Batteriezustand liefern. Der Sensor kann alternativ als Umweltsensor ausgestaltet sein, und als solcher Messwerte der Umwelt des Fahrzeuges messen. Ein Temperatursensor kann in diesem Fall zum Beispiel die Außentemperatur messen. Eine hohe/niedrige Außentemperatur hat einen Einfluss auf die Leistung der Fahrzeugbatterie, weshalb die aktuelle Außentemperatur für den Batteriezustand eine Rolle spielt. Die mindestens eine Betriebsinformation wird vorzugsweise digital übermittelt. Analoge Messsignale bzw. Betriebsparameter können vor dem Versenden in digitale Werte umgewandelt werden. Die mindestens eine Betriebsinformation kann als Datenpaket verschickt bzw. empfangen werden.

Für die Batteriediagnose können Soll-Betriebsparameter mit Ist- Betriebsparametern und/oder Soll-Betriebszuständen mit Ist-Betriebszuständen verglichen werden. Es können verschiedene Betriebsparameter, zum Beispiel verschiedene Betriebsparameter einer einzigen Fahrzeugkomponente, verschiedene Betriebsparameter von verschiedenen Fahrzeugkomponenten oder gleiche Betriebsparameter von verschiedenen Fahrzeugkomponenten, miteinander korreliert werden. Durch Vergleich mit Normwerten oder Tabellen kann dann der Batteriezustand ermittelt werden. Ist zum Beispiel ein Innenwiderstand der Fahrzeugbatterie hoch und ist die Spannung der Fahrzeugbatterie niedrig, kann daraus geschlossen werden, dass die Fahrzeugbatterie defekt ist.

Wenn Störungen, Ausfälle oder Fehler auftreten, kann die beeinträchtigte Fahrzeugkomponente bzw. das entsprechende Fahrzeugsteuergerät einen entsprechenden Fehlercode auslösen, zum Beispiel einen Diagnostic Trouble Code (DTC). Der Fehlercode wird in der Regel durch ein Fahrzeugsteuergerät erzeugt und in einem fahrzeugseitigen Speicher gespeichert. Der Fehlercode sagt also etwas über den Betriebszustand der Fahrzeugkomponente bzw. des Steuergerätes aus. Falls also Fehlercodes für die abgefragten Steuergeräte vorliegen, ist es sinnvoll, diese bei der Bestimmung des Batteriezustandes zu verwenden. Möglicherweise eignet sich die Betriebsinformation des Steuergerätes bei Vorliegen eines bestimmten DTC für eine verlässliche Bestimmung des Batteriezustandes nicht, wodurch ein anderes Steuergerät abgefragt werden soll.

Das Verfahren kann also den folgenden Schritt aufweisen: Feststellen, vorzugsweise basierend auf dem Vorhandensein von Fehlercodes, ob die Betriebsinformation für das Bestimmen des Batteriezustandes geeignet ist. Falls festgestellt wird, dass die Betriebsinforation nicht geeignet ist, zum Beispiel das entsprechende Steuergerät nicht verwendet werden soll, kann eine weitere Anfrage an das Fahrzeug geschickt werden, um Betriebsinformation eines anderen Steuergerätes zu erlangen.

Der Batteriezustand der Fahrzeugbatterie kann mindestens eine der folgenden Größen umfassen oder sein: Ladezustand, SoC-Zustand, Gesundheitszustand, SoH-Zustand, Alterung, Restkapazität und/oder Innenwiderstand. Aus dem ermittelten Batteriestand kann ein Ergebnis und/oder eine Handlungsempfehlung generiert werden, zum Beispiel "Batterie in Ordnung", "Batterie laden", "Batterie ersetzen", "Batterieleistung reduziert", "Batteriezustand kritisch" und/oder "Batterie prüfen".

Die Betriebsinformation kann vor dem Empfangen über eine Fahrzeugdiagnose-Schnittstelle des Fahrzeugs weitergeleitet werden. Hierbei kann das fahrzeugseitige Steuergerät über ein Fahrzeugbussystem mit der Fahrzeugdiagnoseschnittstelle verbunden sein. Falls das Steuergerät ein Gateway ist, ist dieses oftmals direkt mit der Fahrzeugdiagnoseschnittstelle verbunden.

Oftmals ist vorgesehen, dass eine Diagnosevorrichtung die Betriebsinformation von dem fahrzeugseitigen Steuergerät empfängt und den Batteriezustand bestimmt. Die Diagnosevorrichtung muss nicht Bestandteil des Fahrzeuges sein und/oder kann außerhalb des Fahrzeuges angeordnet sein. Die Diagnosevorrichtung kann insbesondere ein mobiles Endgerät, ein Server und/oder ein Fahrzeugdiagnosegerät ist oder dieses/diesen umfassen. Die oben beschriebenen Verfahrensschritte können also insbesondere durch die Diagnosevorrichtung, speziell durch das mobile Endgerät, einen Server und/oder ein Fahrzeugdiagnosegerät durchgeführt werden. Die Diagnosevorrichtung kann während der Durchführung des Verfahrens örtlich vom Fahrzeug getrennt sein, also nicht elektrisch oder mechanisch mit dem Fahrzeug verbunden sein.

Verfahrensmerkmale, die fahrzeugseitig durchgeführt werden können, und zum Beispiel durch eine externe Anfrage veranlasst werden, können mindestens einen der folgenden Schritte aufweisen:
- Senden, durch mindestens ein fahrzeugseitiges Steuergerät, mindestens einer Betriebsinformation, wobei die Betriebsinformation charakteristisch für den Batteriezustand der Fahrzeugbatterie ist oder mit dem Batteriezustand korreliert,
- Empfangen mindestens einer Anfrage zum Senden von Betriebsinformation und/oder Messen von Betriebsparametern,
- Messen eines Betriebsparameters mittels eines Sensors,
- Messen eines Betriebsparameters einer Fahrzeugkomponente mittels eines Sensors,
- Senden, durch das mindestens eine fahrzeugseitige Steuergerät, mindestens einer Fahrzeugantwort, wobei die mindestens eine Fahrzeugantwort die Betriebsinformation, insbesondere den Betriebsparameter umfasst.

Die Fahrzeugbatterie ist insbesondere zum elektrischen Versorgen eines Fahrzeugbordnetzes ausgestaltet. Die Fahrzeugbatterie soll im Sinne der vorliegenden Schrift keine Fahrzeugtraktionsbatterie sein. Eine Fahrzeugtraktionsbatterie liefert im Allgemeinen Hochspannung und hat in vielen Anwendungen eine Nennspannung von 400 V oder sogar 800 V.

Im Automotive-Bereich wird Hochspannung üblicherweise als eine Nennspannung von 48 V oder mehr bezeichnet. Die Nennspannung wird typischerweise dann als eine Niedrigspannung bezeichnet, wenn sie weniger als 48 V beträgt. Die Nennspannung der Fahrzeugbatterie ist in diesem Sinne also eine Niedrigspannung. Oftmals ist die Nennspannung der Fahrzeugbatterie gemäß der vorliegenden Schrift höchstens 30 V, oder höchstens 15 V. Die Nennspannung kann zum Beispiel einen für Kraftfahrzeuge typischen Wert von 12 V oder einen für Nutzfahrzeuge bzw. Lastkraftwagen typischen Wert von 24 V aufweisen. Die Fahrzeugbatterie kann zum Beispiel als Spannungsquelle für das Fahrzeugbordnetz, einen Anlasser, eine Beleuchtung und/oder für die Zündung des Fahrzeuges ausgestaltet sein.

Die oben genannte Fahrzeugkomponente kann eine Lichtmaschine sein. Die Lichtmaschine ist typischerweise ausgestaltet, die Fahrzeugbatterie während des Betriebs des Fahrzeuges / während der Fahrt aufzuladen, und wird auch als Alternator, Generator oder Dynamo bezeichnet.

Aus den Betriebsparametern der Fahrzeugkomponente kann auch ein Betriebszustand der Fahrzeugkomponente ermittelt werden. Falls zum Beispiel stark von einer Norm abweichende Betriebsparameter gemessen werden, kann auf den Betriebszustand "Fahrzeugkomponente ist defekt" geschlossen werden.

Gemäß einem weiteren Aspekt wird ein Verfahren zum Bestimmen eines Lichtmaschinenzustandes bereitgestellt, wobei die Lichtmaschine zum Laden einer Fahrzeugbatterie ausgestaltet ist. Das Verfahren umfasst die Schritte:
- Empfangen mindestens einer Betriebsinformation, vorzugsweise Betriebsinformation einer Lichtmaschine oder einer Fahrzeugbatterie, wobei die Betriebsinformation charakteristisch für den Lichtmaschinenzustand ist oder mit dem Lichtmaschinenzustand korreliert,
- Bestimmen des Lichtmaschinenzustandes mithilfe der Betriebsinformation.

Dieses Verfahren kann einzeln beansprucht werden. Merkmale, die lediglich im Zusammenhang mit dem Verfahren zum Bestimmen des Batteriezustandes offenbart sind, können auch mit dem Verfahren zum Bestimmen des Lichtmaschinenzustandes kombiniert werden. Andersherum können das Verfahren bzw. dessen Verfahrensschritte auch mit dem oben beschriebenen Verfahren zum Bestimmen eines Batteriezustandes kombiniert werden.

Der Lichtmaschinenzustand kann nämlich wiederum charakteristisch für den Batteriezustand sein oder mit dem Batteriezustand korrelieren. Optional kann der oben genannte Schritt "Empfangen mindestens einer Betriebsinformation von einem Fahrzeugsteuergerät, wobei die Betriebsinformation charakteristisch für den Batteriezustand der Fahrzeugbatterie ist oder mit dem Batteriezustand korreliert" also die Schritte "Empfangen mindestens einer Betriebsinformation einer Lichtmaschine, wobei die Betriebsinformation charakteristisch für den Lichtmaschinenzustand ist oder mit dem Lichtmaschinenzustand korreliert, und Bestimmen des Lichtmaschinenzustandes mithilfe der Betriebsinformation" aufweisen. Alternativ können diese Schritte auch zusätzlich vorgesehen sein.

Das Verfahren kann weiter aufweisen:
- Bestimmen des Batteriezustandes basierend auf dem Lichtmaschinenzustand.

Falls die Lichtmaschine nicht in Ordnung ist, zum Beispiel eine zu hohe oder zu niedrige Spannung liefert, eine zu hohe Temperatur aufweist oder einen mechanische Defekt hat, kann dies einen direkten Einfluss auf die Fahrzeugbatterie haben. Selbst wenn die Fahrzeugbatterie momentan in Ordnung ist, beispielsweise weil eine Verschlechterung der Lichtmaschine erst kürzlich eintrat, die Fahrzeugbatterie nach einer langen Fahrt trotzdem voll aufgeladen werden konnte oder die Fahrzeugbatterie zum Beispiel gerade gewechselt wurde, kann die Fahrzeugbatterie bei Vorliegen eines Lichtmaschinendefekts künftig, kurzfristig oder mittelfristig, beschädigt oder nicht hinreichend geladen werden. Der Batteriezustand kann in diesem Fall ein vorhergesagter Batteriezustand sein.

Ähnlich wie oben kann die Betriebsinformation der Lichtmaschine Betriebsparameter der Lichtmaschine, wie Spannung, Widerstand, Temperatur, Strom, oder einen Betriebszustand der Lichtmaschine umfassen, der durch mindestens einen DTC gekennzeichnet sein kann. Sämtliche im Zusammenhang mit dem Batteriezustand offenbarten Merkmale können auch für den Lichtmaschinenzustand gelten und beansprucht werden, soweit nicht technisch ausgeschlossen oder nicht sinnvoll.

Gemäß einem weiteren Aspekt wird eine Diagnosevorrichtung vorgeschlagen. Die Diagnosevorrichtung ist ausgestaltet zum Durchführen mindestens eines der Verfahren der zuvor beschriebenen Art.

Die Diagnosevorrichtung weist oftmals eine Kommunikationsvorrichtung und einen Prozessor auf. Die Kommunikationsvorrichtung kann mit einer fahrzeugseitigen Diagnoseschnittstelle verbindbar sein, insbesondere elektrisch, mechanisch und/oder drahtlos. Die Kommunikationsvorrichtung ist ausgestaltet zum Empfangen der mindestens einen Betriebsinformation von dem fahrzeugseitigen Steuergerät. Der Prozessor ist ausgestaltet zum Bestimmen des Batteriezustandes oder Lichtmaschinenzustandes mithilfe der mindestens einen Betriebsinformation des fahrzeugseitigen Steuergerätes.

Gemäß einem weiteren Aspekt wird ein System vorgeschlagen. Das System umfasst die Diagnosevorrichtung der zuvor beschriebenen Art sowie eine weitere Kommunikationsvorrichtung, welche ausgestaltet ist, die Betriebsinformation von dem fahrzeugseitigen Steuergerät an die Diagnosevorrichtung weiterzuleiten. Die Diagnosevorrichtung und die weitere Kommunikationsvorrichtung sind vorzugsweise über eine Luftschnittstelle kommunikativ miteinander verbunden. Die Kommunikationsvorrichtung kann mit einer fahrzeugseitigen Diagnoseschnittstelle verbindbar sein, insbesondere elektrisch, mechanisch, beispielsweise über eine Steckverbindung, und/oder drahtlos.

Es sei an dieser Stelle betont, dass Merkmale, die nur in Bezug auf das Verfahren genannt wurden, auch für die genannten Vorrichtungen bzw. das genannte System beansprucht werden können und umgekehrt. Es versteht sich, dass die oben beschriebenen Ausführungsformen miteinander kombiniert werden können, sofern sich die Kombinationen nicht gegenseitig ausschließen.

Im Folgenden werden Ausführungsformen der Erfindung anhand beigefügter Zeichnungen näher erläutert. Hierbei sind die Figuren schematisiert und teilweise vereinfacht. Gezeigt werden:
- Fig. 1: eine schematische Darstellung eines Systems zum Durchführen einer Batteriediagnose;
- Fig. 2: eine schematische Darstellung eines weiteren Systems zum Durchführen einer Batteriediagnose;
- Fig. 3: eine schematische Darstellung eines weiteren Systems zum Durchführen einer Batteriediagnose;
- Fig. 4: eine schematische Darstellung eines weiteren Systems zum Durchführen einer Batteriediagnose;
- Fig. 5: eine schematische Darstellung eines weiteren Systems zum Durchführen einer Batteriediagnose;
- Fig. 6: eine schematische Darstellung eines Verfahrensablaufs einer Batteriediagnose.

In den Figuren sind wiederkehrende Merkmale mit denselben Bezugszeichen versehen.

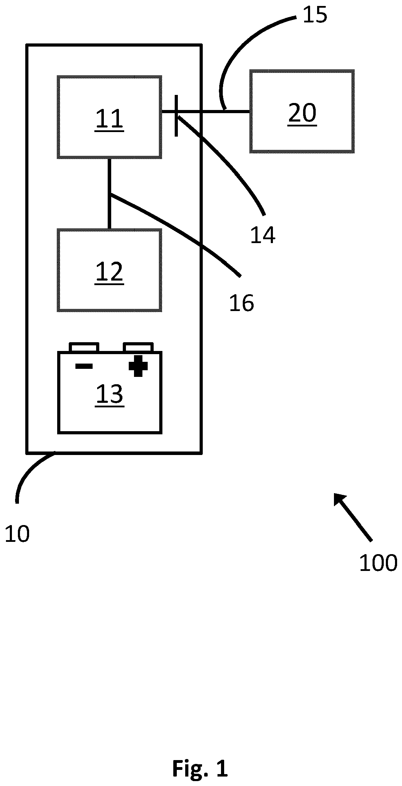

Die Fign. 1-5 zeigen schematisch Darstellungen von verschiedenen Systemen 100 zum Durchführen einer Diagnose eines Fahrzeuges 10 (Fahrzeugdiagnose). Speziell handelt es sich bei der Diagnose um eine Fahrzeugbatteriediagnose. Bei dem Fahrzeug 10 kann es sich zum Beispiel um einen Personenkraftwagen, ein Motorrad, einen Lastkraftwagen oder Ähnliches handeln. Das Fahrzeug 10 weist eine Vielzahl von Steuergeräten 11, 12 auf, z.B. mindestens 10 oder mehr. Viele der oder sämtliche Steuergeräte 11, 12 sind jeweils mindestens einer Fahrzeugkomponente zugeordnet. Die zunehmende Vernetzung von Steuergeräten 11, 12 in heutigen Kraftfahrzeugen bietet immer bessere Einwirkungsmöglichkeiten auf Funktionalitäten im Fahrzeug 10, z.B. bessere Diagnosemöglichkeiten im Fehlerfall oder Möglichkeiten zur Fernbedienung von Funktionen und/oder Komponenten des Fahrzeugs 10. Üblicherweise sind die Steuergeräte 11, 12 miteinander z.B. über ein Fahrzeugbussystem 16, typischerweise ein CAN-Bussystem, verbunden. Hierbei kann das Steuergerät 11 in Fig. 1 repräsentativ für eine erste Gruppe von Steuergeräten 11 sein. Das zweite Steuergerät 12 in Fig. 1 kann repräsentativ für eine zweite Gruppe von Steuergeräten 12 sein.

Die Steuergeräte 11, 12 sind üblicherweise jeweils mit einer Vielzahl von Sensoren verbunden, die während des Betriebs des Fahrzeuges 10 Messwerte oder Betriebsparameter erfassen. Denkbare Sensormessgrößen umfassen beispielsweise eine Kühlmitteltemperatur, eine Motortemperatur, eine Öltemperatur, eine Fahrzeuggeschwindigkeit, eine Motordrehzahl, ein Motordrehmoment, eine Umgebungstemperatur (Außentemperatur), einen Umgebungsluftdruck, einen Ladedruck eines Abgasturboladers des Antriebsmotors, einen eingelegten Gang eines Getriebes des Fahrzeugs 10, einen elektrischen Strom, eine elektrische Spannung, einen elektrischen Widerstand usw.. Falls ein durch einen Sensor gemessener Messwert einen bestimmten Sollwertbereich je nach Sensorgröße unter- oder überschreitet, erzeugt das entsprechende Steuergerät 11, 12 oftmals einen Fehlercode, der üblicherweise in einem Speicher des jeweiligen Steuergeräts 11, 12 gespeichert wird. Der Fehlercode ist einem Fehlerzustand zugeordnet und beinhaltet beispielsweise eine Kennziffer zur Identifikation von Fehlfunktionen, die während des Betriebs eines Fahrzeugs auftreten können. Der Fehlercode wird auch als Diagnosefehlercode oder Diagnostic Trouble Code (DTC) bezeichnet. Außerdem können die Steuergeräte 11, 12 direkt oder zumindest indirekt, z.B. über das Fahrzeugbussystem 16 wie CAN-Bussystem 16, mit einer Fahrzeugdiagnoseschnittstelle 14 verbunden sein. Statt auf einzelne Komponenten 11, 12 des Fahrzeuges 10 wird nachstehend der Einfachheit halber manchmal lediglich auf das Fahrzeug 10 Bezug genommen.

Das Fahrzeug 10 weist eine Fahrzeugbatterie 13 auf, welche typischerweise eine Nennspannung von 12 V in Personenkraftwagen bzw. eine Nennspannung von 24 V in Lastkraftwagen aufweist. Die Fahrzeugbatterie 13 ist ausgelegt, ein Fahrzeugbordnetz mit Strom zu versorgen und ist typischerweise als Spannungsquelle für einen Anlasser, eine Beleuchtung und/oder die Zündung des Fahrzeuges 10 ausgestaltet. Die Steuergeräte 11, 12 sind in der Regel auch elektrisch mit der Fahrzeugbatterie 13 verbunden und beziehen ihre Energie zumindest zeitweise daraus.

Manche Elektrofahrzeuge oder Hybridfahrzeuge weisen zudem noch eine Traktionsbatterie auf, welche mit einer deutlich höheren Nennspannung von 400 V oder 800 V für den Antrieb eines Elektromotors des Fahrzeuges 10 verwendet wird.

Weiter zeigt die Fig. 1 eine Diagnosevorrichtung 20, die typischerweise eine Steuer- und Verarbeitungseinheit, einen Speicher sowie Kommunikationsmittel umfasst. Üblicherweise kann die Diagnosevorrichtung 20 mittels Signalleitungen 15 (also drahtgebunden) an die Fahrzeugdiagnoseschnittstelle 14 des Fahrzeuges 10 angeschlossen werden, und somit mit dem CAN-Bussystem 16 und den Steuergeräten 11, 12 in Verbindung stehen.

In manchen Ausführungsformen ist die Diagnosevorrichtung 20 als dediziertes Fahrzeugdiagnosegerät ausgestaltet und als solches ausgebildet, eine Diagnose des Fahrzeuges 10, insbesondere der Fahrzeugbatterie 13 durchzuführen.

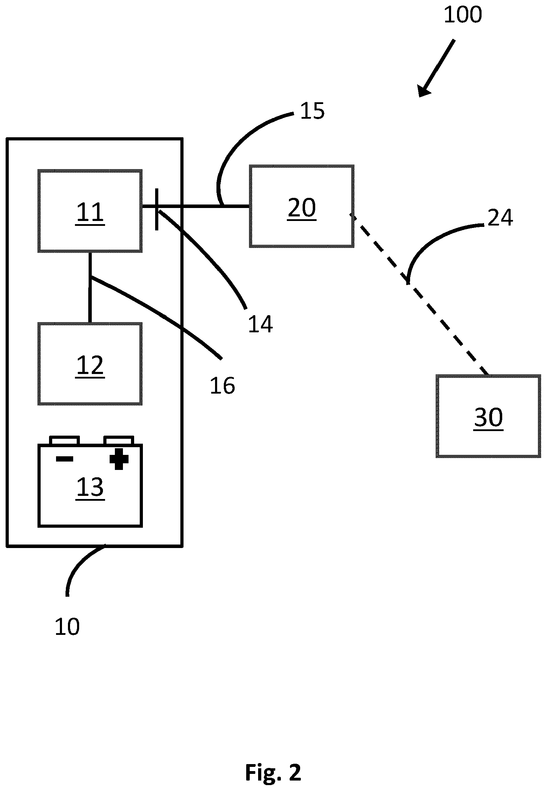

In manchen Ausführungsformen kann die Diagnosevorrichtung 20 als OBD-Dongle ausgestaltet sein, welche vorrangig eine Kommunikation zwischen dem Fahrzeug 10 und externen Einheiten 30, 40 vermittelt, vgl. Fign. 2-5. Die in dieser Schrift verwendete Abkürzung OBD steht hierbei für "on-board diagnosis".

Die Diagnosevorrichtung 20 weist typischerweise einen Stecker auf, der mit der Fahrzeugdiagnoseschnittstelle 14 kompatibel ist und in diese eingesteckt werden kann. Beim Verbinden des Steckers mit der Fahrzeugdiagnoseschnittstelle 14 werden beide elektrisch und mechanisch miteinander verbunden. Der Stecker kann direkt an einem Gehäuse der Diagnosevorrichtung 20 vorgesehen sein, zum Beispiel im Falle eines Dongles. Alternativ kann der Stecker auch mittels eines Verlängerungskabels mit weiteren Komponenten der Diagnosevorrichtung 20 verbunden sein, zum Beispiel im Falle des dedizierten Fahrzeugdiagnosegeräts. In manchen Fällen kann alternativ oder zusätzlich eine drahtlose Kommunikationsverbindung der Diagnosevorrichtung 20 mit dem Fahrzeug 10 und den Steuergeräten 11, 12 möglich sein, zum Beispiel eine Drahtlos-Nahverbindung wie Bluetooth oder WiFi. Die Diagnosevorrichtung 20 kann ausgestaltet sein, nach außengehende Datenströme der Steuereinheiten 11, 12 zu verarbeiten und/oder zum Fahrzeug 10 gehende Datenströme von externen Einheiten 30, 40 zu verarbeiten, insbesondere wenn die Diagnosevorrichtung als OBD-Dongle vorliegt. Die Diagnosevorrichtung 20 kann eine erste Sende- und Empfangseinheit und eine zweite Sende- und Empfangseinheit aufweisen, welche einerseits für die Kommunikation bzw. Datenstrom zum Fahrzeug 10 hin bzw. andererseits für die Kommunikation bzw. Datenstrom aus dem Fahrzeug 10 heraus vorgesehen sind. Wie in der Fig. 1 gezeigt ist, ist auch lediglich eine Kommunikation zwischen dem Fahrzeug und der Diagnosevorrichtung möglich, also ohne weitere Einheiten 30, 40.

Die Diagnosevorrichtung 20 kann über Luftschnittstellen 24, 25, 35 kommunikativ mit weiteren Einheiten 30, 40 verbunden sein. Die Luftschnittstelle 24, welche die Diagnosevorrichtung 20 mit dem mobilen Endgerät 30 verbindet, kann als Nahfeldverbindung ausgestaltet sein, beispielsweise Bluetooth oder WiFi/WLAN. Die Luftschnittstellen 25, 35 können beispielsweise Verbindungen mittels eines Mobilfunknetzes gemäß einem der Mobilfunk-Standards G1-G5 oder höher einschließen, insbesondere wenn über sie eine Verbindung einer der Einheiten 20, 30 mit dem Server 40 hergestellt wird. Die Diagnosevorrichtung 20 kann durch ein Identifikationsmerkmal, z.B. IMEI (international mobile equipment identity), eindeutig identifizierbar sein.

In manchen Ausführungsformen ist das Steuergerät 11 für den Empfang und das Senden von Daten über das Fahrzeugbussystem 16 innerhalb des Fahrzeuges 10 konfiguriert ist. Das Steuergerät11 kann zum Beispiel für die Gewährleistung von Sicherheitsfunktionen zuständig sein. Beispielhafte Steuergeräte 11 umfassen ein Bordnetzsteuergerät und/oder ein Gateway. Je nach Hersteller sind das Gateway und/oder das Bordnetzsteuergerät im Fahrzeug 10 vorhanden und bilden zusammen mit der Diagnoseschnittstelle 24 eine Kommunikationsbrücke zwischen dem Fahrzeug 10 und externen Einheiten 20, 30, 40.

Das Gateway ist hierbei üblicherweise als Kommunikationsvorrichtung im Fahrzeug 10 ausgestaltet und ermöglicht eine Kommunikation des Fahrzeuges 10 mit der Außenwelt über die Diagnoseschnittstelle 14. Das Gateway kann somit als Datenverteiler für die Kommunikation innerhalb des Fahrzeuges 10 und über die Kommunikationsschnittstelle 14 mit der Außenwelt agieren. Oftmals unterstützt das Gateway unterschiedliche Fahrzeugbussysteme 16 wie Ethernet, CAN, LIN und kann beispielsweise mit einem zusätzlichen Diagnosebussystem verbunden sein. Das Diagnosebussystem kann Bestandteil des Fahrzeugbussystems 16 sein oder zusätzlich zum Fahrzeugbussystem 16 vorliegen und über das Gateway mit dem Fahrzeugbussystem 16 verbunden sein.

Als Bordnetzsteuergerät oder abgekürzt BSG, im Englischen Body Control Module (BCM), bezeichnet man ein oder auch mehrere Steuergeräte im Fahrzeug 10, die unmittelbar elektrische Verbraucher bzw. Teilnehmer am Bordnetz (wie beispielsweise Beleuchtung oder Scheibenwaschanlage) steuern, Daten der Fahrzeugbussysteme 16 (LIN, CAN, Flexray) verarbeiten und/oder auch als Gateway für Diagnosedienste fungieren. Komfortfunktionen wie Sitzheizung oder Ambientelicht werden üblicherweise ebenfalls vom BSG bedient.

Beispielhafte Steuergeräte 12 umfassen ein Batteriesteuergerät zum Steuern der Fahrzeugbatterie 13, ein Lichtmaschinensteuergerät zum Steuern der Lichtmaschine, Antriebssteuergeräte zum Steuern von Antriebskomponenten des Fahrzeugs 10 wie Motor oder Getriebe, und/oder Komfortsteuergeräte zum Steuern von Komfortsystemen, wie Heizung oder Kühlung.

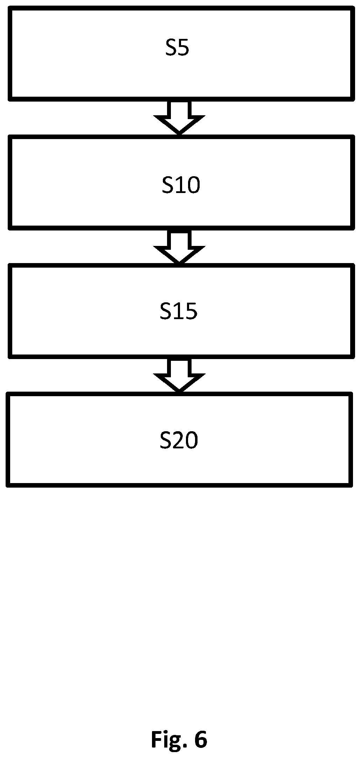

Gemäß einem Aspekt der vorliegenden Schrift wird ein Verfahren zum Bestimmen eines Batteriezustandes der Fahrzeugbatterie 13 bereitgestellt. Die nachstehend beschriebenen Schritte S5, S10, S15, S20 können zum Beispiel durch die Diagnosevorrichtung 20, das mobile Endgerät 30 oder den Server 40 durchgeführt werden. Ein schematischer Ablauf des Verfahrens ist in der Fig. 6 dargestellt.

Das Verfahren weist folgende Schritte auf:
- S10: Empfangen mindestens einer Betriebsinformation von mindestens einem fahrzeugseitigen Steuergerät 11, 12, wobei die Betriebsinformation charakteristisch für den Batteriezustand der Fahrzeugbatterie 13 ist oder mit dem Batteriezustand korreliert.

Die Betriebsinformation kann einen Betriebsparameter der Fahrzeugkomponente und/oder einen Betriebszustand der Fahrzeugkomponente umfassen. Typische Betriebsparameter, welche sich für die Batteriediagnose eignen, umfassen zum Beispiel Temperatur, Spannung, Strom und/oder elektrischer Widerstand der entsprechenden Fahrzeugkomponente. Zusätzliche Betriebsparameter umfassen zum Beispiel Außentemperatur, Lastzustand Lichtmaschine, Ist Drehmoment Klimakompressor, Ist Stromaufnahme Heckscheibenheizung, Drehzahl von Elektromotoren, Anlasser Lüftungsmotor, Zustand der Klemmen, Auswertung des elektrisch durchgeführten Kompressionstest, Ist-Steuerungsvorgaben vs. Soll-Steuerungsvorgaben sowie weitere tatsächliche Betriebsparameter. Die Betriebsinformation wird hierbei vorzugsweise digital, insbesondere als Datenpaket übermittelt.

Der mindestens eine Betriebsparameter kann durch einen im Fahrzeug 10, insbesondere an oder in der Fahrzeugkomponente, oder an oder im Steuergerät 11, 12, verbauten Sensor gemessen werden und/oder aus durch den Sensor ermittelten Messwerten ermittelt werden. Hierfür kommen die oben beschriebenen Sensoren in Frage.

Auch Umweltsensoren kommen für das beschriebene Verfahren in Frage. So unterscheidet sich eine Hysterese der Fahrzeugbatterie bei tiefen Außentemperaturen wie Minusgraden von der Hysterese bei hohen Außentemperaturen wie über 30° C. Die Außentemperatur kann somit auch als relevanter Parameter in die Bestimmung des Batteriezustandes einfließen.

Verschiedene Optionen sind denkbar: so können verschiedene Betriebsinformationen einer einzigen Fahrzeugkomponente über ein Steuergerät 11, 12 versandt werden, es können verschiedene Betriebsinformationen von verschiedenen Fahrzeugkomponenten über ein Steuergerät 11, 12 versandt werden, oder es können verschiedene Betriebsinformationen von verschiedenen Fahrzeugkomponenten über verschiedene Steuergeräte 12 an das Steuergerät 11 gesandt werden.

Die Fahrzeugkomponente kann die Fahrzeugbatterie 13, eine Lichtmaschine des Fahrzeuges 10, also Generator des Fahrzeuges 10, das Fahrzeugbussystem 16, oder eine andere Komponente des Fahrzeuges 10 sein. Die Fahrzeugkomponente kann auch das Steuergerät 11, 12 selbst sein. In diesem Fall schickt das Steuergerät 11, 12 die Betriebsinformationen von sich selbst an die Einheit 20, 30, 40.
- S20: Bestimmen des Batteriezustandes mithilfe der mindestens einen Betriebsinformation der Fahrzeugkomponente.

Der Batteriezustand der Fahrzeugbatterie 13 kann hierbei mindestens eine der folgenden Größen umfassen oder sein: Ladezustand, SoC-Zustand, Gesundheitszustand, SoH-Zustand, Alterung, Restkapazität und/oder Innenwiderstand. Weiter können als Batteriezustand eine verbleibende Kapazität, eine nutzbare Batterieladung und/oder eine angelernte Batteriekapazität nach einem Batteriewechsel oder wenn die Ersatzbatterie von der Originalbatterie abweicht, in Frage kommen.

Vor dem Senden (bzw. Empfangen durch eine der Einheiten 20, 30, 40) kann die Betriebsinformation von dem Steuergerät 12 an das Steuergerät 11 geschickt werden und über die Fahrzeugdiagnoseschnittstelle 14 des Fahrzeugs 10 an externe Einheiten 20, 30, 40 weitergeleitet werden.

Optional kann die Betriebsinformation über eine Anfrage angefordert werden. In diesem Fall kann das Verfahren die weiteren Schritte aufweisen:
- S5: Senden mindestens einer Anfrage an das Fahrzeug 10, insbesondere an das mindestens eine fahrzeugseitige Steuergerät 11, 12, und
- S15: Empfangen mindestens einer Fahrzeugantwort von dem Fahrzeug 10, insbesondere von dem mindestens einen fahrzeugseitigen Steuergerät 11, 12, wobei die mindestens eine Fahrzeugantwort die Betriebsinformation umfasst.

Die Schritte S10 und S15 können in einem einzigen Schritt verwirklicht werden. Die Anfrage kann insbesondere eine Aufforderung zum Bereitstellen der Betriebsinformation enthalten, insbesondere Bereitstellen von aktuellen Betriebsinformation bzw. Ist-Betriebsinformation.

Das Verfahren kann alternativ oder zusätzlich folgende Schritte aufweisen:
- Empfangen einer Betriebsinformation, welcher charakteristisch für den Lichtmaschinenzustand ist oder mit dem Lichtmaschinenzustand korreliert,
- Bestimmen des Lichtmaschinenzustandes mithilfe der Betriebsinformation des fahrzeugseitigen Steuergerätes 11, 12.

Es kann mithilfe der Betriebsinformation festgestellt werden, ob die Lichtmaschine elektrisch, mechanisch und/oder thermisch in Ordnung ist. Weiter kann geprüft werden, ob eine Zuschaltung und/oder Abschaltung der Lichtmaschine in Ordnung ist, oder ob die Lichtmaschine die nötige Leistung bereitstellt / bereitstellen kann, um die Fahrzeugbatterie zu laden.

Der Lichtmaschinenzustand kann wiederum mit dem Batteriezustand korrelieren bzw. charakteristisch für den Batteriezustand sein. Daher kann der Batteriezustand wiederum basierend auf dem Lichtmaschinenzustand bestimmt werden.

Für die Batteriediagnose können Soll-Betriebsparameter mit Ist- Betriebsparametern und/oder Soll-Betriebszuständen mit Ist-Betriebszuständen verglichen werden. Es können verschiedene Betriebsparameter, zum Beispiel verschiedene Betriebsparameter einer einzigen Fahrzeugkomponente, verschiedene Betriebsparameter von verschiedenen Fahrzeugkomponenten oder gleiche Betriebsparameter von verschiedenen Fahrzeugkomponenten, miteinander korreliert werden. Durch Vergleich mit Normwerten oder Tabellen kann dann der Batteriezustand ermittelt werden. In der Tabelle 1 unten sind ein paar Beispiele für Betriebsinformationen und den daraus abgeleiteten Batteriezustand gezeigt.

**Tabelle 1: Betriebsinformationen und Batteriezustand**

| **Betriebsinformation** | **Batteriezustand** |
|---|---|
| Innenwiderstand Fahrzeugbatterie hoch Spannung Fahrzeugbatterie niedrig | Defekt |
| Lichtmaschine Spannung hoch Sitzheizung Spannung niedrig Batteriespannung hoch | Batterie i.O. |
| Anlasserdrehzahl niedrig Batteriespannung niedrig Batterietemperatur hoch Außentemperatur niedrig Kompressionstest i.O Ladezustand Batterie niedrig | Batterie laden |
| | |
| Leistung Heckscheibenheizung niedrig Batterietemperatur niedrig Innenwiderstand hoch Ruhespannung niedrig Verfügbare Restkapazität Batterie 0 | Defekt |
| Außentemperatur niedrig Innenraumtemperatur hoch Kühlmitteltemperatur hoch Glühkerzenstromaufnahme niedrig Ruhespannung hoch Batteriespannung normal | Batterie i.O |
| Ruhespannung niedrig | Batterie laden |
| Ladeanforderung Lichtmaschinen Hoch Batterieladezustand niedrig | |
| Steuergeräteversorgungsspannung niedrig OBD_Versorgungspannung niedrig Status Klemme 15 => aktiv Status Klemme 30 => aktiv Drehmoment Klimakompressor => reduziert Start/Stop System => Prohibition durch Batterie Leerlaufdrehzahl 0 U/min | Leistung Batterie eingeschränkt |
| Drehzahl Gebläsemotor Lüftung niedrig Stufe Gebläsemotor Lüftung maximum Last Lichtmaschine hoch Ruhespannung niedrig Batteriespannung niedrig Auswertung Kompressionstest in Ordnung | Batterie laden |

Die in der Tabelle 1 genannte Ruhespannung ist die unbelastete Spannung der Batterie 13, insbesondere nachdem die Zündung deaktiviert wurde und alle Verbraucher eingeschlafen sind. Die in der Tabelle genannte Batteriespannung kann in jedem Zustand der Batterie 13 (belastet und unbelastet) oder Fahrzeugzustand gemessen werden. Beide Betriebsparameter Ruhespannung und Batteriespannung können also gemessen werden und mit Soll-Werten verglichen werden.

Die Tabelle 2 zeigt bespielhaft, dass der Lichtmaschinenzustand aus verschiedenen Betriebsinformationen abgeleitet werden kann. Falls die Lichtmaschine defekt ist, hat dies in der Regel einen direkten Einfluss auf den künftigen Batteriezustand. Die Batterie 13 kann nämlich bei einer defekten Lichtmaschine nicht ordnungsgemäß geladen werden oder sogar kaputt gehen.

**Tabelle 2: Betriebsinformationen und Lichtmaschinenzustand**

| **Betriebsinformation** | **Lichtmaschinenzustand** |
|---|---|
| Ist Last Lichtmaschine hoch Soll Last Lichtmaschine hoch | Lichtmaschine defekt (elektrisch) |
| Temperatur Lichtmaschine normal Ruhespannung niedrig Batteriespannung niedrig Auswertung Kompressionstest in Ordnung | |
| Lastanforderung Lichtmaschine hoch Ist Last Lichtmaschine niedrig Temperatur Lichtmaschine normal Ruhespannung hoch Batteriespannung niedrig Auswertung Kompressionstest in Ordnung | Lichtmaschine defekt (mechanisch) |
| Lastanforderung Lichtmaschine hoch Ist Last Lichtmaschine niedrig Temperatur Lichtmaschine hoch Ruhespannung niedrig Batteriespannung niedrig Auswertung Kompressionstest in Ordnung | Lichtmaschine defekt (thermisch) |
| Lastanforderung Lichtmaschine hoch Ist Last Lichtmaschine hoch Temperatur Lichtmaschine normal Ruhespannung niedrig Batteriespannung hoch Auswertung Kompressionstest in Ordnung | Lichtmaschine i.O. |

In manchen Ausführungsformen empfängt die Diagnosevorrichtung 20 die Betriebsinformation und leitet hieraus den Batteriezustand ab. Wie schon oben angedeutet ist die Diagnosevorrichtung 20 nicht Bestandteil des Fahrzeuges 10 ist und kann außerhalb des Fahrzeuges 10 angeordnet sein.

Das Fahrzeugdiagnosegerät 20, das mobile Endgerät 30 und/oder der Server 40 können jeweils eine Kommunikationsvorrichtung aufweisen, um eine Kommunikation mit den anderen Einheiten zu ermöglichen. Die wechselseitige Kommunikation der Einheiten 20, 30, 40 ist in den Figuren 1-5 mittels Linien angedeutet. Hierbei können gestrichelte Linien bedeuten, dass die Kommunikation drahtlos bzw. über eine Luftschnittstelle erfolgt, während durchgezogene Linien auf eine drahtgebundene Kommunikation hinweisen.

Weiter können die Diagnosevorrichtung 20, das mobile Endgerät 30 und/oder der Server 40 jeweils einen Prozessor aufweisen, um Daten auszuwerten bzw. den Batteriezustand aus der Betriebsinformation zu bestimmen. Über die Kommunikationsvorrichtung der Einheiten 20, 30, 40 kann die Betriebsinformation empfangen werden und anschließend ausgewertet werden, zum Bestimmen des Batteriezustandes, oder weitergeleitet werden, sodass die Bestimmung des Batteriezustandes in einer anderen Einheit stattfinden kann.

Das Verfahren kann während des Betriebs des Fahrzeuges 10 und/oder während einer Fahrt durchgeführt werden. Alternativ kann das Verfahren auch in der Werkstatt oder an einem anderen Ort durchgeführt werden. Es ist jedenfalls nicht notwendig, dass die Einheit 20, 30, 40, welche die Betriebsinformation auswertet, physisch in der Nähe des Fahrzeugs 20 anwesend ist. Vielmehr kann die Auswertung der Betriebsinformation zum Bestimmen des Batteriezustandes auch "remote" stattfinden.

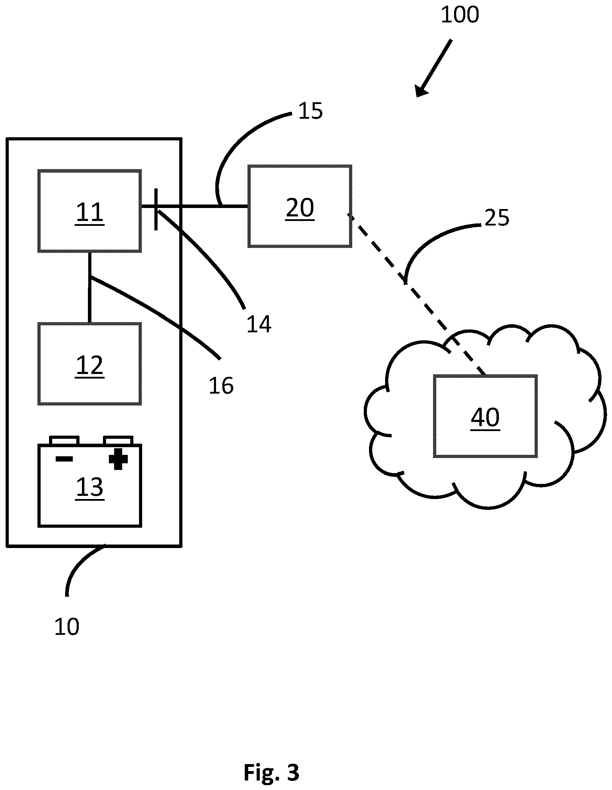

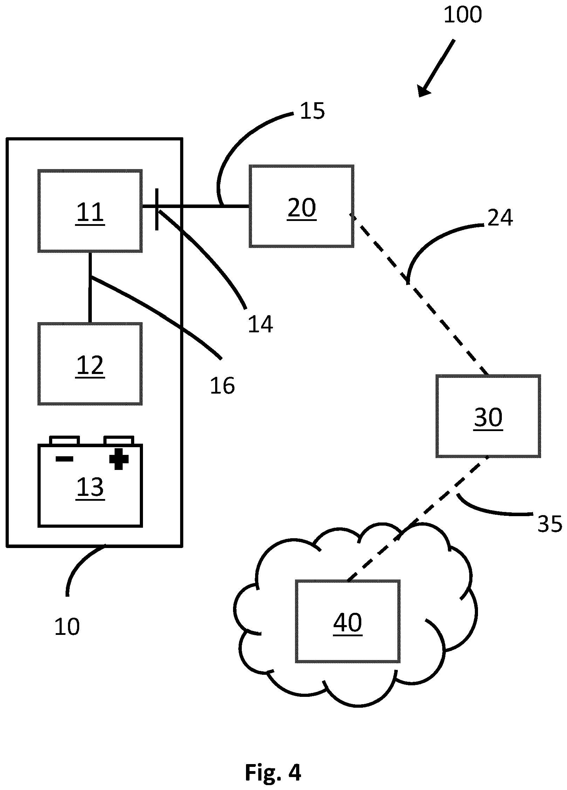

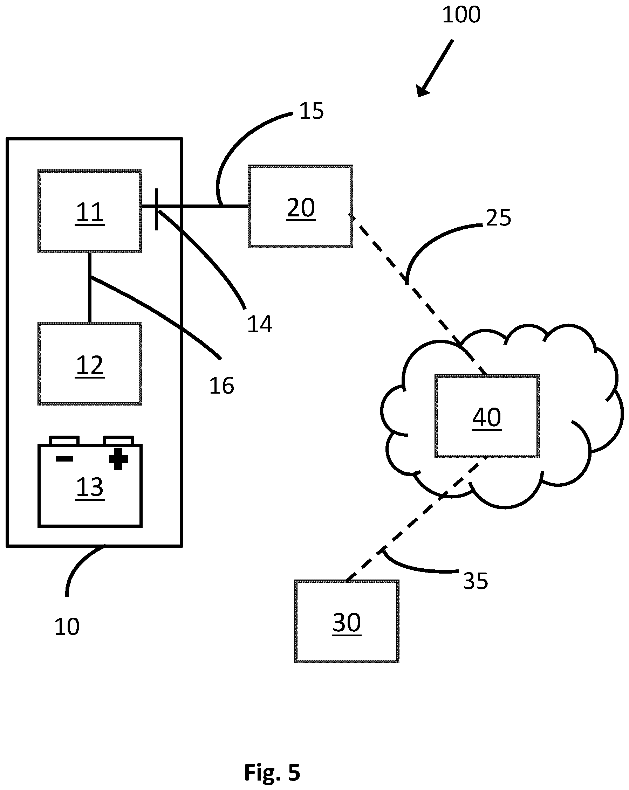

Die "Remote"-Auswertung der Betriebsinformation für die Batteriediagnose ist in den Figuren 2-5 gezeigt. Hier wird die Betriebsinformation zum Beispiel von dem Steuergerät 11 über die Diagnoseschnittstelle 14 und die Signalleitungen 15 an die Vorrichtung 20 geschickt, welche die Betriebsinformation daraufhin an ein mobiles Endgerät 30 (Fig. 2, 4) oder an einen Server 40 (Fig. 3, 5) schickt. In den Figuren 2 und 3 findet die Bestimmung des Batteriezustandes dann im mobilen Endgerät 30 bzw. Server 40 statt. In den Figuren 4 und 5 wird die Betriebsinformation noch einmal vom mobilen Endgerät 30 zum Server 40 bzw. vom Server 40 zum mobilen Endgerät 30 geschickt, wo dann anschließend die Batteriediagnose durchgeführt wird.

### Bezugszeichenliste

- 10: Fahrzeug
- 11: Fahrzeugsteuergerät
- 12: Fahrzeugsteuergerät
- 13: Fahrzeugbatterie
- 14: OBD-Schnittstelle
- 15: Signalleitungen
- 16: Fahrzeugbussystem
- 20: Fahrzeugdiagnosegerät / OBD-Dongle
- 25: Luftschnittstelle
- 30: mobiles Endgerät
- 35: Luftschnittstelle
- 40: Server
- 100: System

## Patentansprüche

1. Verfahren zum Bestimmen eines Batteriezustandes einer Fahrzeugbatterie (13), wobei die Fahrzeugbatterie (13) eine Nennspannung von weniger als 48 V aufweist, umfassend die Schritte:
- Empfangen mindestens einer Betriebsinformation von einem fahrzeugseitigen Steuergerät (11, 12), wobei die Betriebsinformation charakteristisch für den Batteriezustand der Fahrzeugbatterie (13) ist oder mit dem Batteriezustand korreliert,
- Bestimmen des Batteriezustandes mithilfe der mindestens einen Betriebsinformation.

2. Verfahren nach Anspruch 1, umfassend die Schritte:
- Senden mindestens einer Anfrage an das Fahrzeug (10), insbesondere an das mindestens eine fahrzeugseitige Steuergerät (11, 12), um die Betriebsinformation bereitzustellen, und
- Empfangen mindestens einer Fahrzeugantwort von dem Fahrzeug (10), insbesondere von dem mindestens einen fahrzeugseitigen Steuergerät (11, 12), wobei die mindestens eine Fahrzeugantwort die Betriebsinformation umfasst.

3. Verfahren nach einem der vorstehenden Ansprüche, wobei das fahrzeugseitige Steuergerät (11, 12) ein Batteriesteuergerät, Bordnetzsteuergerät, Lichtmaschinensteuergerät, Motorsteuergerät und/oder Gateway ist oder umfasst.

4. Verfahren nach einem der vorangehenden Ansprüche, wobei das Fahrzeug (10) neben dem fahrzeugseitigen Steuergerät (11, 12) ein Batteriesteuergerät und/oder ein Lichtmaschinensteuergerät umfasst, wobei für die Bestimmung des Batteriezustandes zusätzlich mindestens eine Betriebsinformation des Batteriesteuergerätes und/oder des Lichtmaschinensteuergerätes herangezogen wird.

5. Verfahren nach einem der vorangehenden Ansprüche, wobei die Betriebsinformation einen Betriebsparameter und/oder einen Betriebszustand umfasst, wobei die Betriebsinformation mindestens eines der folgenden Elemente umfasst oder ist: Fehlercode, DTC, Temperatur, Spannung, Strom und/oder elektrischer Widerstand.

6. Verfahren nach einem der vorstehenden Ansprüche, wobei der Batteriezustand der Fahrzeugbatterie (13) mindestens eine der folgenden Größen umfasst oder ist: Ladezustand, SoC-Zustand, Gesundheitszustand, SoH-Zustand, Alterung, Restkapazität und/oder Innenwiderstand.

7. Verfahren nach einem der vorstehenden Ansprüche, soweit rückbezogen auf Anspruch 5, wobei der mindestens eine Betriebsparameter durch einen Sensor gemessen wird und/oder aus durch den Sensor ermittelten Messwerten ermittelt wird.

8. Verfahren nach einem der vorstehenden Ansprüche, umfassend die Schritte:
- Empfangen mindestens einer Betriebsinformation, wobei die Betriebsinformation charakteristisch für den Lichtmaschinenzustand ist oder mit dem Lichtmaschinenzustand korreliert,
- Bestimmen des Lichtmaschinenzustandes mithilfe der Betriebsinformation, wobei der Lichtmaschinenzustand charakteristisch für den Batteriezustand ist oder mit dem Batteriezustand korreliert, und
- Bestimmen des Batteriezustandes basierend auf dem Lichtmaschinenzustand.

9. Verfahren nach einem der vorstehenden Ansprüche, wobei die Betriebsinformation vor dem Empfangen über eine Fahrzeugdiagnoseschnittstelle (14) des Fahrzeugs (10) weitergeleitet wird, wobei das fahrzeugseitige Steuergerät (12) über ein Fahrzeugbussystem (16) mit der Fahrzeugdiagnoseschnittstelle (14) verbunden ist.

10. Verfahren nach einem der vorstehenden Ansprüche, wobei das Verfahren während des Betriebs des Fahrzeuges (10) und/oder während einer Fahrt durchgeführt wird.

11. Verfahren nach einem der vorstehenden Ansprüche, wobei eine Diagnosevorrichtung die Betriebsinformation empfängt und den Batteriezustand bestimmt, wobei die Diagnosevorrichtung nicht Bestandteil des Fahrzeuges (10) ist und/oder außerhalb des Fahrzeuges (10) angeordnet ist, wobei die Diagnosevorrichtung insbesondere ein mobiles Endgerät (30), ein Server (40) und/oder ein Fahrzeugdiagnosegerät (20) ist.

12. Verfahren nach einem der vorstehenden Ansprüche, wobei Betriebsinformationen von mindestens zwei verschiedenen fahrzeugseitigen Steuergeräten (11, 12) empfangen werden, und der Batteriezustand mithilfe der Betriebsparameter bestimmt wird.

13. Verfahren nach einem der vorstehenden Ansprüche, wobei die mindestens eine Betriebsinformation digital und/oder als Datenpaket übermittelt wird.

14. Vorrichtung (20, 30, 40), ausgestaltet zum Durchführen des Verfahrens gemäß einem der vorstehenden Ansprüche.

15. Vorrichtung (20, 30, 40) gemäß dem vorstehenden Anspruch, umfassend eine Kommunikationsvorrichtung, welche mit einer fahrzeugseitigen Diagnoseschnittstelle (14) verbindbar ist, insbesondere elektrisch, mechanisch und/oder drahtlos, wobei die Kommunikationsvorrichtung ausgestaltet ist zum Empfangen der mindestens einen Betriebsinformation, und
die Vorrichtung weiter umfassend einen Prozessor, welcher ausgestaltet ist zum Bestimmen des Batteriezustandes oder Lichtmaschinenzustandes mithilfe der mindestens einen Betriebsinformation.
